# EUROPÄISCHE PATENTSCHRIFT

(11) **EP 1 783 904 B1**
(45) Veröffentlichungstag und Bekanntmachung des Hinweises auf die Patenterteilung: **16.04.2008**
(21) Anmeldenummer: 05022558.0
(22) Anmeldetag: 17.10.2005
(51) Int. Cl.: H03H 11/30, H01J 37/32

(54) **HF-Plasmaversorgungseinrichtung**
HF plasma supply system
Appareil d'alimentation de puissance à haute-fréquence pour plasma

(43) Veröffentlichungstag der Anmeldung: 09.05.2007
(73) Patentinhaber: HÜTTINGER Elektronik GmbH + Co. KG, 79111 Freiburg (DE)
(72) Erfinder: Kirchmeier, Thomas, 79331 Teningen (DE); Glück, Michael, 79111 Freiburg (DE); Gerhardt, Christoph, 79106 Freiburg (DE); Mann, Ekkehard, 79194 Gundelfingen (DE); Hofstetter, Christoph, 79331 Teningen (DE); Hintz, Gerd, 79292 Pfaffenweiler (DE)
(74) Vertreter: Schiz, Jochen

(56) Entgegenhaltungen:
- EP-A- 0 731 559
- US-A1- 2003 215 373
- US-B1- 6 259 334

## Beschreibung

Die Erfindung betrifft ein Verfahren zum Steuern und/oder Regeln der Ausgangsleistung einer HF-Plasmaversorgungseinrichtung, umfassend die Verfahrensschritte:
a. Erzeugen zumindest eines ersten und eines zweiten HF-Leistungssignals mittels jeweils eines HF-Generators;
b. Kopplung zumindest zweier HF-Leistungssignale in Abhängigkeit der Phasenlage und/oder der Pegel (Amplituden) der HF-Leistungssignale zu einer gekoppelten HF-Leistung;
c. Aufteilen der gekoppelten HF-Leistung auf eine einer Plasmalast zuzuführenden Plasmaleistung und eine einer Ausgleichslast zuzuführenden Ausgleichsleistung,
sowie eine HF-Plasmaversorgungseinrichtung.

Für Plasmaversorgungseinrichtungen und/oder die darin angeordneten HF-Generatoren werden vom Hersteller Nennleistungen angegeben, wobei die Summe der Nennleistungen der einzelnen HF-Generatoren die Nennleistung der Plasmaversorgungseinrichtung darstellt (Siehe z.B. EP 0 731 559 A1).

Es ist bekannt, dass HF-Generatoren und damit HF-Plasmaversorgungseinrichtungen bei einem Bruchteil ihrer Nennleistung nur sehr schwer betrieben werden können. Sie neigen zu unkontrollierten Schwingungen und lassen sich nur schwer auf eine genaue Ausgangsleistung regeln. Zumeist wird von Herstellern von HF-Generatoren auch eine untere Leistungsgrenze angegeben, unterhalb derer der HF-Generator nicht zuverlässig oder nicht mit der erforderlichen Genauigkeit betrieben werden kann. Diese kann z.B. 10% der Nennleistung betragen, sie kann aber auch bei niedrigeren Werten liegen, z.B. bei 1%. Die Summe der unteren Leistungsgrenzen der HF-Generatoren ergibt dabei in etwa die untere. Leistungsgrenze der Plasmaversorgungseinrichtung.

Es ist bekannt, für den Betrieb der Plasmaversorgungseinrichtung unterhalb der unteren Leistungsgrenze einem zusätzlichen Widerstand einen ersten Teil der Leistung zuzuführen und den restlichen Teil der Leistung der Last zuzuführen und so den HF-Generator oberhalb dessen unterer Leistungsgrenze zu betreiben. Man kann dazu den Widerstand in Reihe oder parallel zur Last anschließen. Für kleine Leistungen unterhalb der unteren Leistungsgrenze bietet diese Lösung meist ein brauchbares Ergebnis. Dieser Widerstand muss, wenn die Leistung, die an die Last geliefert wird, in Richtung Nennbereich ansteigt, abgetrennt werden, da ihm sonst eine sehr hohe Leistung zugeführt würde, was große Verluste und einen hohen Kühlaufwand bedeuten würde. Da der Widerstand in den bekannten Ausführungen nicht regelbar ist, muss er schlagartig abgetrennt werden, ein kontinuierliches Durchfahren eines weiten Leistungsbereiches ist so nicht möglich.

Von HF-Plasmaversorgungseinrichtungen wird verlangt, dass sie sich in einem weiten Leistungsbereich sehr genau einstellen lassen. Dieser Leistungsbereich soll kontinuierlich durchfahren werden können.

Aufgabe der vorliegenden Erfindung ist es daher, ein Verfahren und eine Vorrichtung bereitzustellen, mit denen diesbezüglich Abhilfe geschaffen werden kann.

Diese Aufgabe wird durch ein Verfahren der eingangs genannten Art gelöst, wobei eine Steuerung und/oder Regelung der Pegel und/oder der Phasenlage der HF-Leistungssignale derart erfolgt, dass für Plasmaleistungen im Bereich zwischen einer vorgegebenen unteren Leistungsgrenze und einer vorgegebenen Nennleistung ein unwesentlicher Teil der gekoppelten HF-Leistung die Ausgleichsleistung darstellt und für Plasmaleistungen unterhalb der vorgegebenen unteren Leistungsgrenze ein wesentlicher Teil der gekoppelten HF-Leistung die Ausgleichsleistung darstellt. Mit diesem Verfahren ist es möglich, eine Plasmaversorgungseinrichtung über einen weiten Leistungsbereich, insbesondere auch beim Betrieb unterhalb der unteren Leistungsgrenze, stabil zu betreiben. Ein großer Leistungsbereich kann ohne Probleme abgedeckt und im Wesentlichen kontinuierlich durchfahren werden. Dabei werden die HF-Leistungsgeneratoren vorzugsweise so angesteuert, dass alle in etwa dieselbe HF-Leistung abgeben.

Eine Plasmalast kann eine Vakuumplasmabearbeitungskammer, z.B. zum Beschichten, Ätzen oder Bearbeiten von Substraten mittels eines Plasmas, bzw. ein darin ablaufender Plasmaprozess, oder eine Laseranregung in einem Gaslaser sein.

Im Rahmen der Erfindung werden unter HF-Frequenzen Frequenzen im Bereich zwischen 1 und 30MHz verstanden. Bevorzugte Frequenzen bei Plasmalasten sind 13MHz und 27MHz.

Vorzugsweise wird für Plasmaleistungen im Bereich zwischen einer vorgegebenen unteren Leistungsgrenze und einer vorgegebenen Nennleistung eine geringere Ausgleichsleistung eingestellt als für Plasmaleistungen unterhalb der vorgegebenen unteren Leistungsgrenze. Die untere Leistungsgrenze kann beispielsweise in Abhängigkeit von der Nennleistung vorgegeben werden. Beispielsweise kann als untere Leistungsgrenze eine Leistung im Bereich von 0,1% bis 20% der Nennleistung vorgegeben werden. Vorzugsweise wird die untere Leistungsgrenze als etwa 10% der Nennleistung vorgegeben.

Besonders bevorzugt ist eine Verfahrensvariante, bei der die Pegel und/oder Phasen der HF-Leistungssignale, insbesondere beim Betrieb der HF-Plasmaversorgungseinrichtung im Bereich der Nennleistung, eingestellt werden, indem die Gleichstrom- und/oder Gleichspannungsversorgung der HF-Leistungsgeneratoren gesteuert und/oder geregelt wird. Durch diese Vorgehensweise lässt sich der Pegel der Plasmaleistung, insbesondere in einem Leistungsbereich oberhalb der unteren Leistungsgrenze, besonders einfach einstellen. Im einfachsten Fall sind genau zwei HF-Generatoren und ein Koppelglied zur Addition der HF-Leistungssignale vorhanden. Die Nennleistung jedes HF-Generators beträgt beispielsweise 1,5kW, sie arbeiten beispielsweise beide bei 13,56MHz. Arbeitet die HF-Plasmaversorgungseinrichtung im Bereich >10% ihrer Nennleistung, so werden die Phasenlage und die Pegel der beiden HF-Generatoren so eingestellt, dass möglichst die gesamte gekoppelte HF-Leistung an die Plasmalast geliefert wird. Das sind bei Nennleistung dann 3kW. Die Leistungssteuerung erfolgt zum Beispiel durch die Steuerung der Gleichstrom- oder Gleichspannungszufuhr der HF-Generatoren. Arbeitet die HF-Plasmaversorgungseinrichtung im Bereich <10% ihrer Nennleistung, also kleiner 300W Plasmaleistung, so erfolgt die Steuerung der Plasmaleistung dann vorzugsweise nicht mehr zwingend durch die Steuerung der Pegel der HF-Leistungssignale der HF-Generatoren (beispielsweise durch Steuerung der Gleichspannungs- oder Gleichstromversorgung), sondern vorzugsweise überwiegend durch die Steuerung der Phasenlage der beiden HF-Generatoren zueinander.

Vorteilhafterweise werden die HF-Leistungssignale erzeugt, indem schaltende Elemente in den HF-Generatoren angesteuert werden. Im Schaltbetrieb arbeitende HF-Generatoren sind besonders verlustarm und werden deswegen für größere Leistungen bevorzugt eingesetzt. HF- Generatoren, die im Schaltbetrieb arbeiten, sind bekannt, z.B. Class-D (Vollbrücke oder Halbbrücke) oder Class-E, F Verstärker oder Mischformen davon. Diese Art von HF-Generatoren weisen einen oder mehrere schaltende Elemente und einen Ausgangskreis auf. Die schaltenden Elemente werden mit einem Schaltsignal einer Schaltfrequenz ein- und ausgeschaltet.

Der Ausgangskreis hat im Wesentlichen zwei Aufgaben: Erstens das Filtern des HF-Leistungssignals, so dass im Wesentlichen nur die Schaltfrequenz zum Ausgang gelangt. Zweitens soll er das verlustarme Schalten der schaltenden Elemente ermöglichen. Die Ausgangsleistung des einzelnen HF-Generators kann zum Beispiel durch die Gleichspannungs- oder Gleichstromzufuhr gesteuert werden. Die im Schaltbetrieb arbeitenden HF-Generatoren arbeiten bei Frequenzen oberhalb 1MHz üblicherweise mit MOSFETs als schaltenden Elementen. Diese MOSFETs haben eine Ausgangskapazität Coss, die nichtlinear von der Spannung am Ausgang des MOSFETs zwischen dem Drain und Source-Anschluss abhängig ist. Während die Kapazität für hohe Ausgangsspannungen (z.B. größer 100V) nur geringfügig mit zunehmender Spannung langsam abfällt, steigt die Kapazität bei niedrigen Ausgangsspannungen (z.B. kleiner 40V) bei fallenden Spannungen sehr stark an und kann um Potenzen (z.B. Faktor 100, 1000) größer werden, als der Wert bei großen Spannungen. Dies macht den Betrieb von im Schaltbetrieb arbeitenden HF-Generatoren bei kleinen Spannungen kompliziert, vor allem, wenn sie eigentlich für den Betrieb bei großen Spannungen ausgelegt sind, weil sich die Kapazität immer auf den Ausgangskreis der im Schaltbetrieb arbeitenden HF-Generatoren auswirkt. Ändert sich aber ein Wert in der Schaltung sehr stark, so verändert dies das Verhalten des Ausgangskreises und er kann seine beiden Aufgaben nicht mehr oder nicht mehr richtig wahrnehmen. Dadurch wird die Leistungseinstellung bei im Verhältnis zur Nennleistung niedrigen Ausgangsleistungen sehr kompliziert. Für viele Anwendungen bei Vakuumplasmaprozessen wird aber eine sehr exakte Leistungseinstellung über einen sehr weiten Leistungsbereich gefordert, insbesondere auch bei Leistungen, die sehr viel kleiner als die Nennleistung der HF-Plasmaversorgungseinrichtung sind. Ein zusätzliches Problem ist, dass die Änderung dC/dU bei kleinen Spannungen sehr groß ist. Das führt zu Nichtlinearitäten des Verhaltens des Ausgangskreises.

Mit dieser Erklärung ist klar, dass der Wert für die untere Leistungsgrenze im Regelfall nicht fest bei 10% der Nennleistung liegt, sondern sich in Abhängigkeit der gewünschten Nennleistung und der gewünschten niedrigsten einzustellenden Leistung im Bereich von 0,1% bis 20% der Nennleistung ändern kann. Maßgebend bei im Schaltbetrieb arbeitenden HF-Generatoren ist die Nichtlinearität der Ausgangskapazität und die Toleranz der Schaltung, die auch abhängt von der maximalen Spannung am schaltenden Element, der Frequenz, der Leistung etc.

Auf besonders einfache Art und Weise können die Pegel und/oder Phasen der HF-Leistungssignale eingestellt werden, indem die schaltenden Elemente in einem Phase-Shift-Verfahren angesteuert werden. Beispielsweise kann ein HF-Generator zwei Halbbrücken aufweisen, die jeweils aus zwei wechselseitig schaltenden Elementen bestehen. Durch die Ansteuerung der schaltenden Elemente werden die Phasenlage der Halbbrücken und damit die Leistung am Ausgang des HF-Generators eingestellt. Auch bei diesem Prinzip der Leistungsregelung können sehr kleine Leistungen nur noch unzureichend genau eingestellt werden. Die Steuerung und/oder Regelung der einer Ausgleichslast zuzuführenden Leistung ist also auch bei dieser Art der Erzeugung der HF-Leistungssignale vorteilhaft, um die gesamte HF-Plasmaversorgungseinrichtung zuverlässig betreiben zu können.

Besonders bevorzugt ist es, wenn eine Grobeinstellung der gekoppelten HF-Leistung erfolgt, indem die Gleichstrom- und/oder Gleichspannungsversorgung der HF-Generatoren gesteuert und/oder geregelt wird, eine Feineinstellung der gekoppelten HF-Leistung erfolgt, indem eine Phase-Shift-Steuerung der HF-Generatoren erfolgt. Dadurch ist es möglich, für den Betrieb der HF-Plasmaversorgungseinrichtung sowohl unterhalb als auch oberhalb der unteren Leistungsgrenze die Plasmaleistung mit einer sehr großen Genauigkeit einzustellen. Zusätzlich ist es möglich, einzelne HF-Generatoren abzuschalten und die verbleibenden HF-Generatoren oberhalb ihrer eigenen unteren Leistungsgrenze zu betreiben. Insbesondere ist es möglich, die Ausgangsleistung der HF-Plasmaversorgungseinrichtung beim Betrieb unterhalb der unteren Leistungsgrenze ausschließlich über die Leistungsaufteilung einzustellen.

Bei einer vorteilhaften Verfahrensvariante kann vorgesehen sein, dass die HF-Leistungssignale in einem 90° Hybrid, insbesondere in einem 3dB-Koppler, gekoppelt werden. Durch den Einsatz von diesen Kopplern können Mehrfachreflexionen bei Fehlanpassung an der Plasmalast vermieden werden. Dies bedeutet, dass die dem 90° Hybrid vorgeschalteten Generatoren wirksam geschützt werden. Außerdem wird durch einen 90° Hybrid eine Leistungsregelung bei geringen Leistungen ermöglicht. Bei einigen Leistungskopplern, wie zum Beispiel den 90° Hybriden, bedeutet eine Kopplung der HF-Leistungs(eingangs)signale eine Addition der HF-Leistungssignale zu einer addierten HF-Leistung als gekoppelter HF-Leistung. Die addierte HF-Leistung wird dann je nach Pegel und/oder Phasenlage der HF-Leistungssignale auf zwei HF-Leistungs(ausgangs)signale aufgeteilt.

Größere Plasmaleistungen können erzeugt werden, wenn mehr als zwei HF-Leistungssignale erzeugt werden, wobei jeweils zwei HF-Leistungssignale zu einem gekoppelten HF-Leistungssignal gekoppelt werden. Die Kopplung bzw. Addition der HF-Leistungssignale erfolgt vorzugsweise in einem Koppelglied, so dass vorteilhafterweise auch mehrere Ausgleichslasten vorgesehen sind und entsprechend mehrere Ausgleichsleistungen erzeugt werden. Dabei werden in den Koppelgliedern vorzugsweise jeweils zwei HF-Leistungssignale gekoppelt. Mehrere Koppelglieder können kaskadiert werden, so dass am Ende der Kaskade ein HF-Leistungssignal erzeugt wird, welches die einer Plasmalast zuzuführenden Plasmaleistung darstellt.

Vorteilhafterweise wird zumindest eine eine HF-Leistung beschreibende Größe gemessen. Dabei ist es denkbar, die HF-Leistungssignale oder diese beschreibende Größen am Ausgang zumindest eines HF-Generators zu messen. Alternativ oder zusätzlich kann eine die Plasmaleistung und/oder die Ausgleichsleistung beschreibende Größe erfasst werden. Als eine HF-Leistung beschreibende Größe kann entweder die Leistung selbst oder eine Spannung und/oder ein Strom erfasst werden.

Bei einer Verfahrensvariante kann vorgesehen sein, dass die die HF-Leistung beschreibende Größe zur Regelung der gemessenen HF-Leistung oder einer anderen HF-Leistung verwendet wird. So kann beispielsweise eine in einem HF-Generator gemessene Größe verwendet werden, um die von diesem Generator abgegebene HF-Leistung zu regeln. Weiterhin ist es denkbar, dass die erfasste Plasmaleistung verwendet wird, um die HF-Leistung eines oder mehrerer HF-Generatoren zu regeln. Die gemessenen eine HF-Leistung beschreibende Größen werden dabei vorzugsweise einer Steuer - und/oder Regeleinrichtung zugeführt.

Bei einer Ausgestaltung der Erfindung kann vorgesehen sein, dass eine Impedanzanpassung durchgeführt wird. Die Impedanzanpassung wird vorzugsweise zwischen der Plasmalast und der Plasmaversorgungseinrichtung durchgeführt.

In den Rahmen der Erfindung fällt außerdem eine HF-Plasmaversorgungseinrichtung zur Versorgung einer Plasmalast mit Plasmaleistung, umfassend zumindest zwei HF-Generatoren zur Erzeugung eines ersten und zweiten HF-Leistungssignals, und zumindest ein Koppelglied, in dem aus zwei HF-Leistungssignalen eine gekoppelte HF-Leistung erzeugt wird, wobei an das zumindest eine Koppelglied die Plasmalast und eine Ausgleichslast anschließbar oder angeschlossen sind, und mit einer Steuer- und/oder Regeleinrichtung, die die HF-Generatoren steuert und/oder regelt, wobei die Steuer- und/oder Regeleinrichtung zur Durchführung des vorher beschriebenen Verfahrens und/oder seiner Verfahrensvarianten eingerichtet ist. Mit einer solchen Vorrichtung lassen sich die oben beschriebenen Vorteile erreichen.

Besonders bevorzugt ist es dabei, wenn das Verfahren in Hardware, Firmware und/oder Software implementiert ist. Der Vorteil einer Implementierung in Hardware liegt darin, dass eine schnelle, stufenlose Leistungsregelung erfolgen kann. Bei einer Implementierung in Firmware oder Software ist die Steuerung beziehungsweise Regelung leicht konfigurierbar, zuverlässig und kostengünstig bei geringem Pflegeaufwand einstellbar.

Bei einer vorteilhaften Ausführungsform weist die Steuer- und/oder Regeleinrichtung eine erste Steuerung zur Steuerung der Leistungsaufteilung für gekoppelte HF-Leistungen oberhalb der unteren Leistungsgrenze und eine zweite Steuerung für eine Steuerung der Leistungsaufteilung für gekoppelte HF-Leistungen unterhalb der unteren Leistungsgrenze auf. Die erste Steuerung kann dabei insbesondere für die Steuerung der Gleichstromversorgung der HF-Generatoren und/oder eine Phase-Shift-Steuerung wirksam sein und die zweite Steuerung kann für die Steuerung der Phasenlage der HF-Generatoren wirksam sein.

Dabei kann vorgesehen sein, dass die zweite Steuerung einen wesentlichen Anteil der gekoppelten HF-Leistung auf die Ausgleichslast aufteilt, der insbesondere über 10%, vorzugsweise über 20% der gekoppelten HF-Leistung liegt.

Besonders bevorzugt ist es, wenn das Koppelglied als 90° Hybrid, insbesondere als 3dB-Koppler ausgebildet ist. Mit einem derartigen Koppelglied kann das eingangs beschriebene Hinzuschalten und Abtrennen eines Widerstands entfallen. Weiterhin können durch einen 90°-Hybrid sich negativ auf die HF-Generatoren auswirkende Mehrfachreflexionen vermieden werden.

Ein größeres Leistungsspektrum kann abgedeckt und höhere Nennleistungen können erzielt werden, wenn mehr als zwei HF-Generatoren und zumindest zwei, insbesondere kaskadierte, Koppelglieder vorgesehen sind. Zudem erhöht sich die Störunterdrückung bei Fehlanpassung an der Plasmalast mit jeder Kaskade von 90° Hybriden um ein Vielfaches.

Wenn zumindest eine Messeinrichtung zur Messung einer eine HF-Leistung beschreibenden Größe vorgesehen ist, kann nicht nur eine Steuerung der Leistung anhand vorgegebener Leistungswerte sondern auch eine Regelung erfolgen, da eine Rückkopplung möglich wird. Die Messeinrichtungen stehen daher vorzugsweise mit der Steuer- und/oder Regeleinrichtung in Verbindung.

In weiterer bevorzugter Ausgestaltung der Erfindung kann zumindest eine DC-Stromversorgung für die HF-Generatoren vorgesehen sein, die durch die Steuer- und/oder Regeleinrichtung gesteuert und/oder geregelt ist. Dadurch lassen sich die Pegel der HF-Leistungssignale besonders einfach einstellen. Dabei kann eine DC - Stromversorgung für mehrere HF-Generatoren vorgesehen sein oder es kann für jeden HF-Generator eine eigene DC-Stromversorgung vorgesehen sein.

Weitere Merkmale und Vorteile der Erfindung ergeben sich aus der nachfolgenden Beschreibung von Ausführungsbeispielen der Erfindung, anhand der Fig.en der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Fig.en der Zeichnung näher erläutert. Es zeigt:
- Fig. 1: eine erste Ausführungsform einer erfindungsgemäßen HF-Plasmaversorgungseinrichtung;
- Fig. 2: eine zweite Ausführungsform einer HF-Plasmaversorgungseinrichtung;
- Fig. 3: eine Darstellung eines HF-Generators zur Verdeutlichung einer Phase-Shift-Steuerung.

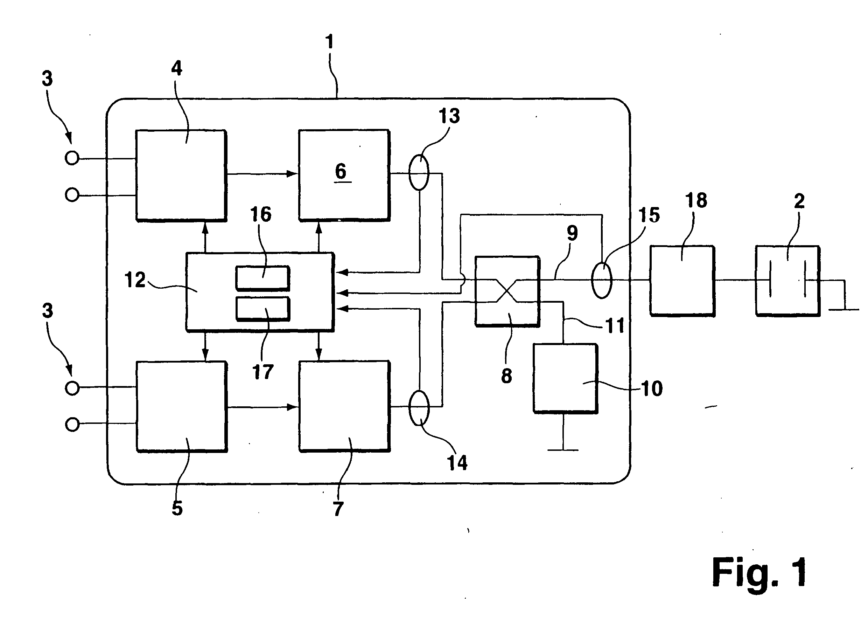

In der Fig. 1 ist eine HF-Plasmaversorgungseinrichtung 1 dargestellt, in der eine Plasmaleistung zur Versorgung einer Plasmalast 2 erzeugt wird. Die gezeigte HF-Plasmaversorgungseinrichtung 1 ist über einen Netzanschluss 3 an ein Spannungsversorgungsnetz angeschlossen, das ein- oder mehrphasig sein kann. Der Netzanschluss 3 kann als Steckkontakt ausgebildet sein. Der Netzanschluss 3 ist mit Gleichstromversorgungen 4, 5 verbunden. Diese sind jeweils einem HF-Generator 6, 7 zugeordnet und versorgen diesen jeweils mit einem Gleichstrom oder einer Gleichspannung. Alternativ kann auch eine gemeinsame Gleichstromversorgung für beide HF Generatoren 6,7 vorgesehen sein. Durch die HF-Generatoren 6, 7 wird jeweils ein HF-Leistungssignal generiert, welches einem als 90°-Hybrid ausgebildeten Koppelglied 8 zugeführt wird. Die HF-Leistungssignale werden in dem Koppelglied 8 zu einer gekoppelten HF-Leistung gekoppelt. Das Koppelglied 8 teilt die gekoppelte HF Leistung auf die Ausgänge 9 und 11 auf. Eine der Plasmalast 2 zuzuführende Plasmaleistung wird an den Ausgang 9 und eine einer Ausgleichslast 10 zuzuführende Ausgleichsleistung wird an den Ausgang 11 gegeben. Je nach Phasenlage der HF-Leistungssignale wird die gekoppelte HF-Leistung unterschiedlich auf die Ausgänge 9, 11 aufgeteilt. Eine nahezu vollständige Weitergabe der gekoppelten HF-Leistung an den Ausgang 9 erfolgt, wenn die HF-Leistungssignale der HF-Generatoren 6, 7 um 90° phasenversetzt sind.

Das Kernstück der HF-Plasmaversorgungseinrichtung 1 ist eine Steuer - und/oder Regeleinrichtung 12, die sowohl die Gleichstromversorgungen 4, 5 als auch die HF-Generatoren 6, 7 regelt und/oder steuert. Die Steuerung und/oder Regelung erfolgt dabei derart, dass beim Betrieb der HF-Plasmaversorgungseinrichtung für eine Plasmaleistung, die im Bereich zwischen einer unteren Leistungsgrenze und einer vorgegebenen Nennleistung liegt, der überwiegende Teil der gekoppelten HF-Leistung an den Ausgang 9 und somit die Plasmalast 2 gegeben wird und nur ein unwesentlicher Teil der gekoppelten HF-Leistung an die Ausgleichslast 10 gegeben wird. In diesem Betriebsbereich werden auch die HF-Generatoren 6, 7 zwischen ihrer unteren Leistungsgrenze und ihrer Nennleistung betrieben. Zu diesem Zweck kann der Signalpegel an den Ausgängen der HF-Generatoren 6, 7 durch eine Steuerung beziehungsweise Regelung der Gleichstromversorgungen 4, 5 eingestellt werden. Alternativ oder zusätzlich können die HF-Generatoren 6, 7, die als im Schaltbetrieb arbeitende HF-Generatoren ausgebildet sind, im Wege eines Phase-Shift-Verfahrens angesteuert werden, um den Pegel der HF-Leistungssignale zu beeinflussen.

Beim Betrieb der HF-Plasmaversorgungseinrichtung 1 in einem Leistungsbereich unterhalb der unteren Leistungsgrenze können die HF-Generatoren 6, 7 durch die Steuer - und/oder Regeleinrichtung 12 derart angesteuert werden, dass die HF-Leistungssignale eine Phasenlage aufweisen, bei der ein überwiegender Teil der gekoppelten HF-Leistung an die Ausgleichslast 10 gegeben wird und nur ein geringer Teil der gekoppelten HF-Leistung an die Plasmalast 2 gegeben wird.

Im gezeigten Ausführungsbeispiel sind Messeinrichtungen 13, 14, 15 zur Erfassung von eine HF-Leistung beschreibenden Größen vorgesehen, die die Größen an die Steuer - und/oder Regeleinrichtung 12 übergeben, so dass eine Regelung einer oder mehrerer HF-Leistungen ermöglicht wird. Die Steuer - und/oder Regeleinrichtung 12 weist im Ausführungsbeispiel eine erste Steuerung 16 auf, die zur Steuerung der Plasmaleistung und der Ausgleichsleistung in einem Leistungsbereich zwischen der unteren Leistungsgrenze und der Nennleistung verwendet wird und eine zweite Steuerung 17, die für die Leistungsregelung in einem darunter liegenden Leistungsbereich verwendet wird. Zwischen dem Ausgang 9 und der Plasmalast 2 ist eine Impedanzanpassung 18 angeordnet.

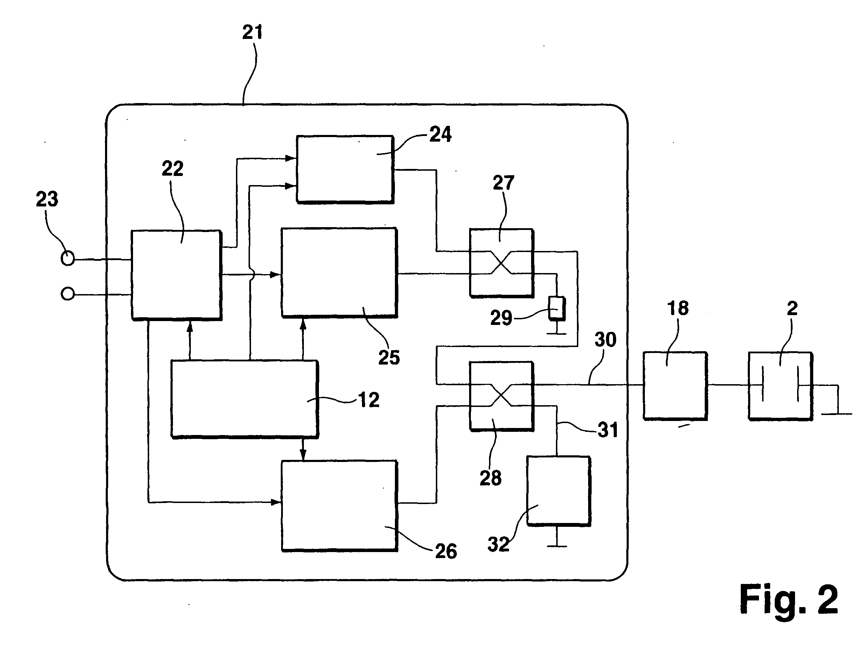

Bei der HF-Plasmaversorgungseinrichtung 21 der Fig. 2 ist eine Gleichstromversorgung 22 an einen Netzanschluss 23 angeschlossen. Die Gleichstromversorgung 22 versorgt drei HF-Generatoren 24, 25, 26 mit einem Gleichstrom und/oder einer Gleichspannung. Die in den HF-Generatoren 24, 25 erzeugten HF-Leistungssignale werden in einem ersten Koppelglied 27 zu einer ersten gekoppelten HF-Leistung gekoppelt. Ein erster Anteil der gekoppelten HF-Leistung wird an ein zweites Koppelglied 28 weitergegeben, während der restliche Teil der gekoppelten HF-Leistung an eine erste Ausgleichslast 29 gegeben wird. Die Aufteilung der gekoppelten HF-Leistung richtet sich nach der Phasenlage der von den HF-Generatoren 24, 25 erzeugten HF-Leistungssignalen. Im zweiten Koppelglied 28 wird die Ausgangsleistung bzw. das am Ausgang des ersten Koppelglieds 27 ausgegebene HF-Leistungssignal zu der im HF-Generator 26 erzeugten HF-Leistung beziehungsweise von diesem ausgegebenen HF-Leistungssignal gekoppelt, so dass eine zweite gekoppelte HF-Leistung entsteht. Je nach Phasenlage des von dem ersten Koppelglied 27 ausgegebenen HF-Leistungssignals und des vom HF-Generator 26 ausgegebenen HF-Leistungssignals wird die zweite gekoppelte HF-Leistung auf eine Plasmaleistung, die über den Ausgang 30 des zweiten Koppelglieds 28 an die Plasmalast 2 gegeben wird und eine Ausgleichsleistung, die über den Ausgang 31 an die zweite Ausgleichslast 32 gegeben wird, aufgeteilt.

Die Steuer - und/oder Regeleinrichtung 12 steuert beziehungsweise regelt in diesem Fall die Gleichstromversorgung 22 und die HF-Generatoren 24 - 26. Messeinrichtungen sind aus Übersichtlichkeitsgründen in der Fig. 2 nicht eingezeichnet. Im gezeigten Ausführungsbeispiel ist das Koppelglied 28 dem Koppelglied 27 nachgeordnet. Somit sind die Koppelglieder 27, 28 kaskadiert.

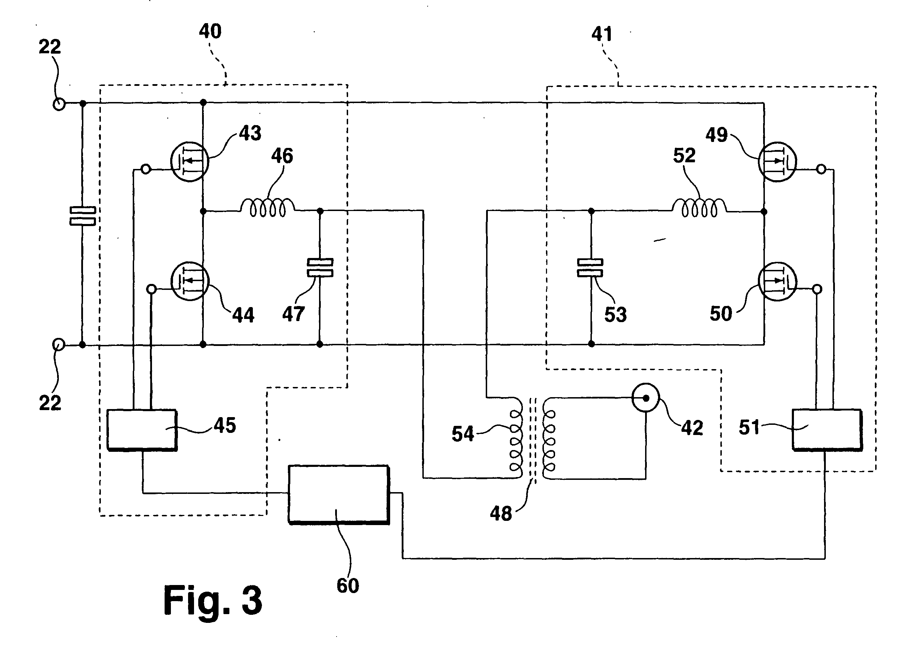

In der Fig. 3 ist der HF-Generator 6 im Detail dargestellt. Der HF-Generator 6 weist zwei Teile 40, 41 auf, die gemäß einer Vollbrückenschaltung angeordnet sind. Die Schaltung gemäß Fig. 3 ermöglicht es, die Leistung am Ausgang 42 einzustellen, indem die Phase zwischen den Schaltsignalen, die den beiden Hälften 40, 41 zugeführt werden, variiert wird. Die erste Hälfte umfasst ein Paar schaltende Elemente 43, 44, die ein Paar von Schaltsignalen erhalten, die von einer Signalquelle 45 ausgegeben werden. Die schaltenden Elemente 43, 44 sind in Serie zwischen die negative und positive Klemmen der Gleichspannungsversorgung 22 geschaltet. Der Ausgang der schaltenden Elemente 43, 44 ist mit einer Induktivität 46 verbunden, die Teil eines Ausgangsschwingkreises ist. Der Ausgangsschwingkreis wird durch die Induktivität 46 und die Kapazität 47 gebildet. Der Ausgang der ersten Hälfte 40 ist mit einer ersten Anzapfung eines Übertragers 48 verbunden.

Die zweite Hälfte 41 umfasst die schaltenden Elemente 49, 50. Eine Signalquelle 51 gibt ein Paar von Schaltsignalen aus, die an die schaltenden Elemente 49,50 gegeben werden. Die Signalquellen 45, 51 können auch zu einer einzigen Einheit vereint werden.

Auch die zweite Hälfte 41 umfasst einen Ausgangsschwingkreis mit einer Induktivität 52 und einer Kapazität 53. Die zweite Hälfte 41 ist mit der zweiten Anzapfung des Übertragers 48 verbunden. Durch den Übertrager 48 wird eine galvanische Trennung zwischen den Hälften 40, 41 und dem Ausgang 42 erzielt. Die Hälften 40, 41 sind durch die Primärwicklung 54 des Übertragers 48 in Serie geschaltet.

Die Hälften 40, 41 sind in Serie geschaltet, so dass eine Veränderung der Phase zwischen den Schaltsignalen, die jede Hälfte 40, 41 ansteuern, die Leistung am Ausgang 42 variiert. Wenn die schaltenden Elemente 43, 49 zu den gleichen Zeitpunkten aktiviert und deaktiviert werden, arbeiten diese in Phase. Wenn dagegen das schaltende Element 43 immer dann ausgeschaltet ist, wenn das schaltende Element 49 eingeschaltet ist und das schaltende Element 43 immer dann eingeschaltet ist, wenn das schaltende Element 49 ausgeschaltet ist, sind die schaltenden Elemente nicht in Phase beziehungsweise um 180° phasenversetzt.

Die Phasenlage zwischen den Hälften 40, 41 wird durch eine Phasensteuerung 60 bestimmt, wobei die Phasensteuerung 60 Teil der Steuer - und/oder Regeleinrichtung 12, insbesondere der Steuerung 16, sein kann. Die Phasensteuerung 60 steuert die Signalquellen 45, 51 an, um den Phasenversatz beziehungsweise die Phasenlage zwischen den beiden Hälften 40, 41 einzustellen. Eine maximale Leistung beziehungsweise ein maximaler Pegel des HF-Leistungssignals wird am Ausgang 42 erzielt, wenn die Hälften 40, 41 mit einem Phasenversatz von 180° betrieben werden. Die geringste Ausgangsleistung wird erzielt, wenn die Hälften 40, 41 in Phase betrieben werden. In diesem Fall sieht jede Hälfte 40, 41 einen Leerlauf unabhängig von der Lastimpedanz. Die anhand der Fig. 3 beschriebene Leistungseinstellung am Ausgang 42 ist eine Leistungseinstellung im Phase-Shift-Verfahren.

## Patentansprüche

1. Verfahren zum Steuern und/oder Regeln der Ausgangsleistung einer HF-Plasmaversorgungseinrichtung (1, 21), umfassend die Verfahrensschritte:
a. Erzeugen zumindest eines ersten und eines zweiten HF-Leistungssignals mittels jeweils eines HF-Generators (6, 7, 24 - 26);
b. Kopplung zumindest zweier HF-Leistungssignale in Abhängigkeit der Phasenlage und/oder der Pegel der HF-Leistungssignale zu einer gekoppelten HF-Leistung;
c. Aufteilen der gekoppelten HF-Leistung auf eine einer Plasmalast (2) zuzuführenden Plasmaleistung und eine einer Ausgleichslast (10, 32) zuzuführenden Ausgleichsleistung;
**gekennzeichnet durch**
d. Steuerung und/oder Regelung der Pegel und/oder der Phasenlage der HF-Leistungssignale derart, dass für Plasmaleistungen im Bereich zwischen einer vorgegebenen unteren Leistungsgrenze und einer vorgegebenen Nennleistung ein unwesentlicher Teil der gekoppelten HF-Leistung die Ausgleichsleistung darstellt und für Plasmaleistungen unterhalb der vorgegebenen unteren Leistungsgrenze ein wesentlicher Teil der gekoppelten HF-Leistung die Ausgleichsleistung darstellt.

2. Verfahren nach Anspruch 1, **dadurch gekennzeichnet, dass** für Plasmaleistungen im Bereich zwischen einer vorgegebenen unteren Leistungsgrenze und einer vorgegebenen Nennleistung eine geringere Ausgleichsleistung eingestellt wird als für Plasmaleistungen unterhalb der vorgegebenen unteren Leistungsgrenze.

3. Verfahren nach Anspruch 1 oder 2, **dadurch gekennzeichnet, dass** die Pegel und/oder Phasen der HF-Leistungssignale, insbesondere beim Betrieb der HF-Plasmaversorgungseinrichtung (1, 21) im Bereich der Nennleistung, eingestellt werden, indem die Gleichstrom- und/oder Gleichspannungsversorgung der HF-Leistungsgeneratoren (6, 7, 24 - 26) gesteuert und/oder geregelt wird.

4. Verfahren nach einem der vorhergehenden Ansprüche, **dadurch gekennzeichnet, dass** die HF-Leistungssignale erzeugt werden, indem schaltende Elemente (43, 44, 49, 50) in den HF-Generatoren (6, 7, 24 - 26) angesteuert werden.

5. Verfahren nach Anspruch 4, **dadurch gekennzeichnet, dass** die Pegel und/oder Phasen der HF-Leistungssignale eingestellt werden, indem die schaltenden Elemente (43, 44, 49, 50) in einem Phase-Shift-Verfahren angesteuert werden.

6. Verfahren nach einem der vorhergehenden Ansprüche, **dadurch gekennzeichnet, dass** eine Grobeinstellung der gekoppelten HF-Leistung erfolgt, indem die Gleichstrom- und/oder Gleichspannungsversorgung der HF-Generatoren (6, 7, 24 - 26) gesteuert und/oder geregelt wird, eine Feineinstellung der gekoppelten HF-Leistung erfolgt, indem eine Phase-Shift-Steuerung der HF-Generatoren (6, 7, 24 - 26) erfolgt.

7. Verfahren nach einem der vorhergehenden Ansprüche, **dadurch gekennzeichnet, dass** die HF-Leistungssignale in einem 90° Hybrid, insbesondere in einem 3dB-Koppler, gekoppelt werden.

8. Verfahren nach einem der vorhergehenden Ansprüche, **dadurch gekennzeichnet, dass** mehr als zwei HF-Leistungssignale erzeugt werden, wobei jeweils zwei HF-Leistungssignale zu einem gekoppelten HF-Leistungssignal gekoppelt werden.

9. Verfahren nach einem der vorhergehenden Ansprüche, **dadurch gekennzeichnet, dass** mehrere Ausgleichsleistungen für mehrere Ausgleichslasten (29, 32) erzeugt werden.

10. Verfahren nach einem der vorhergehenden Ansprüche, **dadurch gekennzeichnet, dass** die Addition von HF-Leistungssignalen in Koppelgliedern (8, 27, 28) erfolgt, wobei mehrere Koppelglieder (27, 28) kaskadiert werden.

11. Verfahren nach einem der vorhergehenden Ansprüche, **dadurch gekennzeichnet, dass** eine eine HF-Leistung beschreibende Größe gemessen wird.

12. Verfahren nach Anspruch 11, **dadurch gekennzeichnet, dass** die die HF-Leistung beschreibende Größe zur Regelung der gemessenen HF-Leistung oder einer anderen HF-Leistung verwendet wird.

13. Verfahren nach einem der vorhergehenden Ansprüche, **dadurch gekennzeichnet, dass** eine Impedanzanpassung durchgeführt wird.

14. HF-Plasmaversorgungseinrichtung (1, 21) zur Versorgung einer Plasmalast (2) mit Plasmaleistung, umfassend zumindest zwei HF-Generatoren (6, 7, 24 - 26) zur Erzeugung eines ersten und zweiten HF-Leistungssignals, und zumindest ein Koppelglied (8, 27, 28), in dem aus zwei HF-Leistungssignalen eine gekoppelte HF-Leistung erzeugt wird, wobei an das zumindest eine Koppelglied (8, 28) die Plasmalast (2) und eine Ausgleichslast (10, 32) anschließbar oder angeschlossen sind, und mit einer Steuer- und/oder Regeleinrichtung (12), die die HF-Generatoren (6, 7, 24 - 26) steuert und/oder regelt, **dadurch gekennzeichnet, dass** die Steuer- und/oder Regeleinrichtung (12) zur Durchführung des Verfahrens nach einem der vorhergehenden Ansprüche eingerichtet ist.

15. HF-Plasmaversorgungseinrichtung nach Anspruch 14, **dadurch gekennzeichnet, dass** das Verfahren in Hardware, Firmware und/oder Software implementiert ist.

16. HF-Plasmaversorgungseinrichtung nach einem der vorhergehenden Ansprüche 14 oder 15, **dadurch gekennzeichnet, dass** das Koppelglied (8, 27, 28) als 90° Hybrid, insbesondere als 3dB-Koppler ausgebildet ist.

17. HF-Plasmaversorgungseinrichtung nach einem der vorhergehenden Ansprüche 14 bis 16, **dadurch gekennzeichnet, dass** mehr als zwei HF-Generatoren (6, 7, 24 - 26) und zumindest zwei, insbesondere kaskadierte, Koppelglieder (27, 28) vorgesehen sind.

18. HF-Plasmaversorgungseinrichtung nach einem der vorhergehenden Ansprüche 14 bis 17, **dadurch gekennzeichnet, dass** zumindest eine Messeinrichtung (13 - 15) zur Messung einer eine HF-Leistung beschreibenden Größe vorgesehen ist.

19. HF-Plasmaversorgungseinrichtung nach einem der vorhergehenden Ansprüche 14 bis 18, **dadurch gekennzeichnet, dass** zumindest eine DC-Stromversorgung (4, 5, 22) für die HF-Generatoren (6, 7, 24 - 26) vorgesehen ist, die durch die Steuer- und/oder Regeleinrichtung (12) gesteuert und/oder geregelt ist.

## Claims

1. Method for controlling and/or regulating the power output of an RF plasma supply device (1, 21), comprising the method steps of:
a. producing at least a first and a second RF power signal by means of a respective RF generator (6, 7, 24 - 26);
b. coupling at least two RF power signals to a coupled RF power in dependance on the phase position and/or the levels of the RF power signals;
c. distributing the coupled RF power between a plasma power which is to be supplied to a plasma load (2) and an equalising power which is to be supplied to an equalising load (10, 32),
**characterised by**
d. controlling and/or regulating the levels and/or the phase position of the RF power signals in such a manner that, for plasma power in the range between a predefined lower power limit and a predefined nominal power, an insignificant portion of the coupled RF power constitutes the equalising power and, for plasma power below the predefined lower power limit, a significant portion of the coupled RF power constitutes the equalising power.

2. Method according to claim 1, **characterised in that**, for plasma power in the range between a predefined lower power limit and a predefined nominal power, a lower equalising power is set than for plasma power below the predefined lower power limit.

3. Method according to claim 1 or 2, **characterised in that** the levels and/or phases of the RF power signals, in particular when the RF plasma supply device (1,21) is operated in the range of the nominal power, are adjusted by the direct current and/or direct voltage supply of.the RF power generators (6, 7, 24 - 26) being controlled and/or regulated.

4. Method according to any one of the preceding claims, **characterised in that** the RF power signals are produced by driving switching elements (43, 44, 49, 50) in the RF generators (6, 7, 24 - 26).

5. Method according to claim 4, **characterised in that** the levels and/or phases of the RF power signals are adjusted by driving the switching elements (43, 44, 49, 50) in a phase-shift method.

6. Method according to any one of the preceding claims, **characterised in that** a coarse adjustment of the coupled RF power is carried out by controlling and/or regulating the direct current and/or the direct voltage supply of the RF generators (6, 7, 24 - 26) and a fine adjustment of the coupled RF power is carried out by carrying out a phase-shift control operation of the RF generators (6, 7, 24 - 26).

7. Method according to any one of the preceding claims, **characterised in that** the RF power signals are coupled in a 90° hybrid, in particular in a 3dB coupler.

8. Method according to any one of the preceding claims, **characterised in that** more than two RF power signals are produced, two RF power signals being coupled to a coupled RF power signal in each case.

9. Method according to any one of the preceding claims, **characterised in that** a plurality of equalising power levels are produced for a plurality of equalising loads (29, 32).

10. Method according to any one of the preceding claims, **characterised in that** the addition of RF power signals is carried out in coupling members (8,:27, 28), a plurality of coupling members (27, 28) being arranged in a cascading manner.

11. Method according to any one of the preceding claims, **characterised in that** a variable is measured which describes an RF power.

12. Method according to claim 11, **characterised in that** the variable which describes the RF power is used to regulate the measured RF power or another RF power.

13. Method according to any one of the preceding claims, **characterised in that** an impedance matching operation is carried out.

14. RF plasma supply device (1, 21) for supplying a plasma load (2) with plasma power, comprising at least two RF generators (6, 7, 24 - 26) for producing a first and a second RF power signal, and at least one coupling member (8, 27, 28) in which a coupled RF power is produced from two RF power signals, the plasma load (2) and an equalising load (10, 32) being connected or being able to be connected to the at least one coupling member (8, 28), and having a control and/or regulation device (12) which controls and/or regulates the RF generators (6, 7, 24 - 26), **characterised in that** the control and/or regulation device (12) is configured to carry out the method according to any one of the preceding claims.

15. RF plasma supply device according to claim 14, **characterised in that** the method is implemented in hardware, firmware and/or software.

16. RF plasma supply device according to either of the preceding claims 14 or 15, **characterised in that** the coupling member (8, 27, 28) is embodied as a 90° hybrid, in particular as a 3dB coupler.

17. RF plasma power supply device according to any one of the preceding claims 14 to 16, **characterised in that** there are provided more than two RF generators (6, 7, 24 - 26) and at least two coupling members (27, 28) which are in particular arranged in a cascading manner.

18. RF plasma supply device according to any one of the preceding claims 14 to 17, **characterised in that** at least one measuring device (13 - 15) is provided for measuring a variable which describes an RF power.

19. RF plasma supply device according to any one of the preceding claims 14 to 18, **characterised in that** at least one DC power supply (4, 5, 22) is provided for the RF generators (6, 7, 24 - 6) and is controlled and/or regulated by the control and/or regulation device (12).

## Revendications

1. Procédé pour commander et/ou réguler la puissance de sortie d'un dispositif d'alimentation de plasma HF (1, 21), comprenant les étapes de procédé suivantes :
a. génération d'au moins un premier et un deuxième signal de puissance HF au moyen d'un générateur HF (6, 7, 24 - 26) ;
b. couplage d'au moins deux signaux de puissance HF en fonction de la relation de phase et/ou des niveaux des signaux de puissance HF en une puissance HF couplée ;
c. répartition de la puissance HF couplée sur une puissance de plasma à amener à une charge de plasma (2) et une puissance de compensation à amener à une charge de compensation (10, 32) ;
**caractérisé par**
d. commande et/ou régulation des niveaux et/ou de la relation de phase des signaux de puissance HF de manière que, pour des puissances de plasma comprises entre une limite de puissance inférieure prédéfinie et une puissance nominale prédéfinie, une partie non essentielle de la puissance HF couplée constitue la puissance de compensation et, pour des puissances de plasma inférieures à la limite de puissance inférieure prédéfinie, une partie essentielle de la puissance HF couplée constitue la puissance de compensation.

2. Procédé selon la revendication 1, **caractérisé en ce que** pour des puissances de plasma comprises entre une limite de puissance inférieure prédéfinie et une puissance nominale prédéfinie, on règle une puissance de compensation plus faible que pour des puissances de plasma inférieures à la limite de puissance inférieure prédéfinie.

3. Procédé selon la revendication 1 ou 2, **caractérisé en ce que** les niveaux et/ou phases des signaux de puissance HF, en particulier lors du fonctionnement du dispositif d'alimentation de plasma HF (1, 21) au voisinage de la puissance nominale, sont réglés en commandant et/ou régulant l'alimentation en courant continu et/ou en tension continue des générateurs de puissance HF (6, 7, 24 - 26).

4. Procédé selon l'une des revendications précédentes, **caractérisé en ce que** les signaux de puissance HF sont générés en commandant des éléments de commutation (43, 44, 49, 50) dans les générateurs HF (6, 7, 24 - 26).

5. Procédé selon la revendication 4, **caractérisé en ce que** les niveaux et/ou phases des signaux de puissance HF sont réglés en commandant les éléments de commutation (43, 44, 49, 50) dans un procédé à décalage de phase.

6. Procédé selon l'une des revendications précédentes, **caractérisé en ce que** l'on effectue un réglage grossier de la puissance HF couplée en commandant et/ou régulant l'alimentation en courant continu et/ou en tension continue des générateurs HF (6, 7, 24 - 26), et l'on effectue un réglage fin de la puissance HF couplée en effectuant une commande par décalage de phase des générateurs HF (6, 7, 24 - 26).

7. Procédé selon l'une des revendications précédentes, **caractérisé en ce que** les signaux de puissance HF sont couplés dans un hybride à 90°, en particulier dans un coupleur 3 dB.

8. Procédé selon l'une des revendications précédentes, **caractérisé en ce que** l'on génère plus de deux signaux de puissance HF, deux signaux de puissance HF étant chaque fois couplés en un signal de puissance HF couplé.

9. Procédé selon l'une des revendications précédentes, **caractérisé en ce que** l'on génère plusieurs puissances de compensation pour plusieurs charges de compensation (29, 32).

10. Procédé selon l'une des revendications précédentes, **caractérisé en ce que** l'on effectue l'addition de signaux de puissance HF dans des éléments de couplage (8, 27, 28), plusieurs éléments de couplage (27, 28) étant montés en cascade.

11. Procédé selon l'une des revendications précédentes, **caractérisé en ce que** l'on mesure une grandeur décrivant une puissance HF.

12. Procédé selon la revendication 11, **caractérisé en ce que** la grandeur décrivant une puissance HF est utilisée pour réguler la puissance HF mesurée ou une autre puissance HF.

13. Procédé selon l'une des revendications précédentes, **caractérisé en ce que** l'on effectue une adaptation d'impédance.

14. Dispositif d'alimentation de plasma HF (1, 21) destiné à alimenter une charge de plasma (2) en puissance de plasma, comprenant au moins deux générateurs HF (6, 7, 24 - 26) pour générer un premier et un deuxième signal de puissance HF, et au moins un élément de couplage (8, 27, 28) dans lequel une puissance HF couplée est générée à partir de deux signaux de puissance HF, la charge de plasma (2) et une charge de compensation (10, 32) pouvant être connectées ou étant connectées audit au moins un élément de couplage (8, 28), et avec un dispositif de commande et/ou de régulation (12) qui commande et/ou régule les générateurs HF (6, 7, 24 - 26), **caractérisé en ce que** le dispositif de commande et/ou de régulation (12) est conçu pour réaliser le procédé selon l'une des revendications précédentes.

15. Dispositif d'alimentation de plasma HF selon la revendication 14, **caractérisé en ce que** le procédé est implémenté en matériel, micrologiciel et/ou logiciel.

16. Dispositif d'alimentation de plasma HF selon l'une des revendications 14 ou 15 précédentes, **caractérisé en ce que** l'élément de couplage (8, 27, 28) est réalisé sous forme d'hybride à 90°, en particulier de coupleur 3 dB.

17. Dispositif d'alimentation de plasma HF selon l'une des revendications 14 à 16 précédentes, **caractérisé en ce que** plus de deux générateurs HF (6, 7, 24 - 26) et au moins deux éléments de couplage (27, 28), en particulier montés en cascade, sont prévus.

18. Dispositif d'alimentation de plasma HF selon l'une des revendications 14 à 17 précédentes, **caractérisé en ce qu'**au moins un dispositif de mesure (13 - 15) pour mesurer une grandeur décrivant une puissance HF est prévu.

19. Dispositif d'alimentation de plasma HF selon l'une des revendications 14 à 18 précédentes, **caractérisé en ce qu'**au moins une alimentation électrique à courant continu (4, 5, 22) pour les générateurs HF (6, 7, 24 - 26) est prévue, laquelle est commandée et/ou régulée par le dispositif de commande et/ou de régulation (12).
